# DEMANDE DE BREVET EUROPEEN

(11) **EP 1 104 104 A2**
(43) Date de publication de la demande: **30.05.2001**
(21) Numéro de dépôt: 00204006.1
(22) Date de dépôt: 14.11.2000
(51) Int. Cl.: H03J 7/18, H03L 7/12

(54) **Procédé d'asservissement pour boucle à verrouillage de phase**

(30) Priorité: 23.11.1999 FR 9914744
(71) Demandeur: Koninklijke Philips Electronics N.V., 5621 BA Eindhoven (NL)
(72) Inventeur: Bedgedjian, Jean-Christophe, 75008 Paris (FR)
(74) Mandataire: de la Fouchardière, Marie-Noelle

(57) **Abrégé**

L'information délivrée en sortie d'un détecteur ne varie linéairement avec l'erreur à détecter que si cette erreur est comprise dans une certaine plage. Lorsqu'on veut récupérer des erreurs plus importantes, on utilise des oscillateurs qui parcourent une large bande de fréquence, morceau par morceau, jusqu'à trouver le morceau de bande sur lequel le détecteur a un fonctionnement linéaire, et donc sur lequel la boucle peut accrocher.

L'invention propose une méthode rapide pour parcourir la bande de fréquence. Cette méthode comporte :
- une étape de sélection d'un morceau de bande initial à parcourir, qui est proche du centre de ladite bande de fréquence,
- une étape de sélection d'un morceau de bande suivant à parcourir, qui est constitué par le morceau de bande non-encore parcouru le plus proche du morceau initial dans le sens des fréquences croissantes ou décroissantes, en fonction d'un critère prédéfini.

Applications : communications numériques

## Description

### Domaine de l'invention

L'invention concerne un système de communication comprenant au moins un émetteur de signaux et un récepteur de signaux, ledit récepteur de signaux étant doté d'au moins une boucle à verrouillage de phase qui comporte un détecteur d'erreur et des moyens d'asservissement d'un oscillateur local susceptible de parcourir une certaine bande de fréquence, morceau par morceau, en vue de minimiser une erreur déterminée par ledit détecteur d'erreur.

L'invention concerne également :
- un récepteur de signaux destiné à être utilisé dans un tel système de communication,
- un circuit intégré qui comporte au moins une telle boucle à verrouillage de phase,
- un procédé d'asservissement d'un oscillateur local utilisé dans une telle boucle à verrouillage de phase,
- et un programme d'ordinateur comportant des moyens de mise en oeuvre d'un tel procédé d'asservissement.
L'invention a d'importantes applications dans le domaine des télécommunications, par exemple pour la réception de signaux numériques diffusés par satellite ou par câble.

### Arrière plan technologique de l'invention

Une telle boucle à verrouillage de phase est notamment décrite aux paragraphes 1-1 et 4-4 de l'ouvrage "Phaselock techniques" de Floyd M. Gardner publié aux Etats-Unis par les éditions John Wiley & sons, Inc. en Avril 1967. Dans cet ouvrage le balayage de la bande de fréquence que l'oscillateur est susceptible de parcourir est obtenu en appliquant à l'entrée de l'oscillateur local une tension qui s'accroît linéairement. Cette tension est par exemple délivrée par un générateur de tension indépendant.

### Résumé de l'invention

L'invention a pour but d'améliorer cette méthode de balayage pour accélérer le verrouillage de la boucle.

Pour cela, un système selon l'invention et tel que décrit dans le paragraphe introductif est caractérisé en ce que lesdits moyens d'asservissement comportent :
- des moyens pour choisir un morceau de bande initial à parcourir, proche du centre de ladite bande de fréquence,
- des moyens pour choisir comme morceau de bande suivant à parcourir, le morceau non-encore parcouru le plus proche du morceau initial dans le sens des fréquences croissantes ou décroissantes, en fonction d'un critère prédéfini.
Au lieu de parcourir linéairement la bande de fréquence dans un sens ou dans un autre, comme c'est le cas dans l'art antérieur cité, l'invention permet de déterminer un ordre de parcourt de la bande de fréquence, morceau après morceau, en fonction d'un critère prédéfini, à partir d'une position sensiblement centrale par rapport à la bande de fréquence à parcourir. L'invention permet ainsi, en moyenne, de limiter le nombre de morceaux de bande à parcourir pour obtenir l'accrochage de la boucle.

Différents critères sont susceptibles d'être utilisés. Dans un premier mode de réalisation, le morceau suivant à parcourir est choisi alternativement dans un sens puis dans l'autre. Dans un deuxième mode de réalisation, il est choisi de façon totalement aléatoire. Et dans un troisième mode de réalisation particulièrement avantageux, il est choisi en fonction du signe de l'erreur obtenue pour le morceau de bande précédent.

### Brève description des dessins

L'invention sera mieux comprise et d'autres détails apparaîtront dans la description qui va suivre en regard des dessins annexés qui sont donnés à titre d'exemples non limitatifs et dans lesquels:
- les figures 1 et 2 représentent chacune un schéma d'un exemple de boucle à verrouillage de phase selon l'invention,
- la figure 3 représente un exemple de procédé de contrôle d'un oscillateur d'une boucle à verrouillage de phase selon l'invention,
- la figure 4 représente un exemple de parcours de la bande de fréquence avec une boucle à verrouillage de phase selon l'invention,
- la figure 5 représente un exemple de système de communication numérique selon l'invention,
- la figure 6 représente un exemple de récepteur de signaux selon l'invention.

### Description d'un mode de réalisation de l'invention

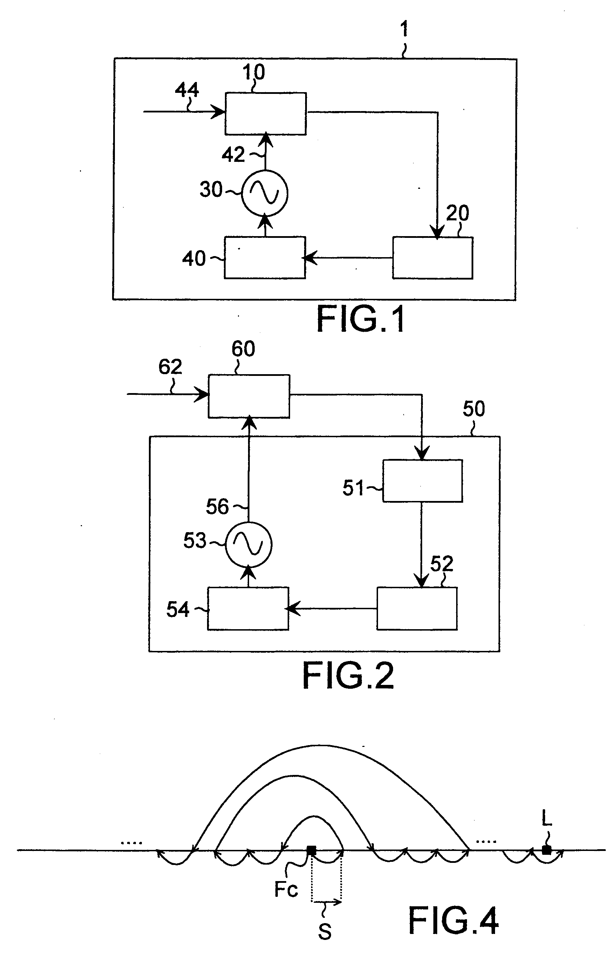

Sur la figure 1 on a représenté un premier exemple de boucle à verrouillage de phase selon l'invention. Cette boucle 1 comporte un détecteur d'erreur 10, un filtre de boucle 20, un oscillateur 30 contrôlé numériquement par un contrôleur 40 pour fournir une oscillation 42. Le détecteur 10 reçoit d'une part l'oscillation 42 fournie par l'oscillateur 30, et d'autre part un signal d'entrée 42. Le contrôleur 40 commande l'oscillateur 30 de façon à asservir l'oscillation 42 sur le signal d'entrée 44.

Sur la figure 2, on a représenté un second exemple de boucle à verrouillage de phase selon l'invention. Cette boucle 50 comporte un détecteur d'erreur 51, un filtre de boucle 52, un oscillateur 53 contrôlé numériquement par un contrôleur 54 pour fournir une oscillation 56 à des moyens de correction 60. Les moyens de correction 60 reçoivent d'une part l'oscillation 56 fournie par l'oscillateur 53 (ou une information dérivée de cette oscillation), et d'autre part un signal d'entrée 62 à corriger. Le signal corrigé est fourni au détecteur d'erreur 51. Le contrôleur 54 commande l'oscillateur 53 de façon à minimiser l'erreur détectée par le détecteur d'erreur 51.

Les détecteurs d'erreur utilisés dans ce type de boucle à verrouillage de phase ont une plage d'acquisition limitée : l'information délivrée en sortie du détecteur ne varie linéairement avec l'erreur à détecter que si cette erreur est comprise dans une certaine plage. Lorsqu'on veut récupérer des erreurs plus importantes, on utilise des oscillateurs qui sont susceptibles de parcourir morceau par morceau une large bande de fréquence, jusqu'à trouver le morceau de la bande sur lequel le détecteur fonctionne correctement, et donc sur lequel la boucle est susceptible d'accrocher. Dans la suite de la description on note F_{c} la fréquence centrale de la plage de fréquence susceptible d'être parcourue par les oscillateurs 30 et 53. La taille des morceaux de bande est notée S.

Sur la figure 3, on a représenté un exemple de procédé d'asservissement mis en oeuvre par les contrôleurs 40 et 54. Ce procédé comporte plusieurs étapes.
- L'étape S1 permet d'initialiser trois variables C, M et N (C=0 ; M=0 et N=1). C est un compteur indiquant le nombre maximum de tentatives d'accrochage à effectuer sur un morceau de bande avant de passer à un morceau de bande suivant. M est un indice indiquant le premier morceau de bande non encore parcouru pour les fréquences inférieures à la fréquence centrale F_{c}. N est un indice indiquant le premier morceau de bande non encore parcouru pour les fréquences supérieures à la fréquence centrale F_{c}. L'étape S1 a également pour but de fixer la fréquence initiale de l'oscillateur F_{O}⁽⁰⁾=F_{C}.
- L'étape S2 est une étape de détection de l'état accroché (L) ou non-accroché (UL) de la boucle. Le procédé d'asservissement se poursuit par l'exécution de l'étape S3 si la boucle n'a pas accroché. Le procédé d'asservissement se termine lorsque la boucle a accroché. La détection de l'état accroché / non-accroché de la boucle se fait par exemple en surveillant la sortie du filtre de boucle. Lorsque la valeur délivrée en sortie du filtre est inférieure à un seuil prédéterminé pendant un nombre de cycles prédéterminés, on considère que la boucle a accroché.
- L'étape S3 permet de déterminer la fréquence qui doit être produite par l'oscillateur. Elle se décompose en plusieurs étapes.
- L'étape S3-1 teste la valeur du compteur C. Si elle est inférieure à un seuil prédéfini K (C<K), le procédé se poursuit par l'exécution de l'étape S3-2. Sinon il se poursuit par l'exécution de l'étape S3-3.
- L'étape S3-2 consiste à incrémenter le compteur C d'une unité (C=C+1), et à déterminer la nouvelle fréquence F_{O}^{(C)} de l'oscillation qui doit être produite par l'oscillateur : dans ce cas F_{O}^{(C)}=F_{O}^{(C-1)}+Δf (où Δf est la correction délivrée par le filtre de boucle). Puis le procédé reprend à l'étape S2.
- L'étape S3-3 a pour but de déterminer le morceau de bande suivant à parcourir. Pour cela elle consiste à remettre le compteur C à zéro (C=0), puis à tester le signe de la correction Δf délivrée par le filtre de boucle. Si Δf est positif ou nul, le morceau de bande suivant à parcourir est le premier morceau de bande non encore parcouru du côté des fréquences supérieures (F_{O}⁽⁰⁾=F_{C}+N.S), et l'indice N est incrémenté d'une unité (N=N+1). Si Δf est négatif, le morceau de bande suivant à parcourir est le premier morceau de bande non encore parcouru du côté des fréquences inférieures (F_{O}⁽⁰⁾=F_{C}-M.S), et l'indice M est incrémenté d'une unité (M=M+1). Le procédé reprend à l'étape S2.

Sur la figure 4 on a représenté un exemple de parcours de la bande de fréquence par l'oscillateur. L'oscillateur parcourt dans l'ordre :
- le morceau de bande centrale (0), puis du côté des fréquences supérieures le morceau de bande (+1),
- puis du côté des fréquences inférieures, les morceaux de bande (-1), (-2), (-3),
- puis du côté des fréquences supérieures, les morceaux de bande (+2) à (+5),
- puis à nouveau du côté des fréquences inférieures, les morceaux de bande (-4) et (-5),
- il effectue encore plusieurs aller-retour entre le côté des fréquences supérieures, et le côtés des fréquences inférieurs,
- finalement après avoir parcouru le morceau de bande (-11) du côté des fréquences inférieures, il rejoint définitivement le côté des fréquences supérieures,
- l'accrochage a lieu sur le morceau de bande (+25).

L'information fournie par le filtre de boucle présente un caractère aléatoire tant que l'erreur à récupérer est très loin de la zone de fonctionnement linéaire du détecteur. Au fur et à mesure que l'on s'approche de la fréquence à atteindre, on obtient de plus en plus d'informations de la part du détecteur. A partir d'un certain écart l'information obtenue devient très fiable, et les morceaux de bande sont toujours parcourus dans le même sens. Finalement, en partant de la fréquence centrale de la bande à parcourir, et en choisissant l'ordre de parcours de la façon qui vient d'être indiquée, l'invention permet de réduire le nombre de morceaux de bande à parcourir pour obtenir l'accrochage.

En dehors de la zone d'accrochage, la sortie du détecteur est porteuse d'information. La convergence est donc plus rapide lorsqu'on utilise comme critère de choix le signe de la correction en sortie du filtre de boucle, que lorsqu'on utilise un critère totalement aléatoire, ou au contraire totalement déterminé.

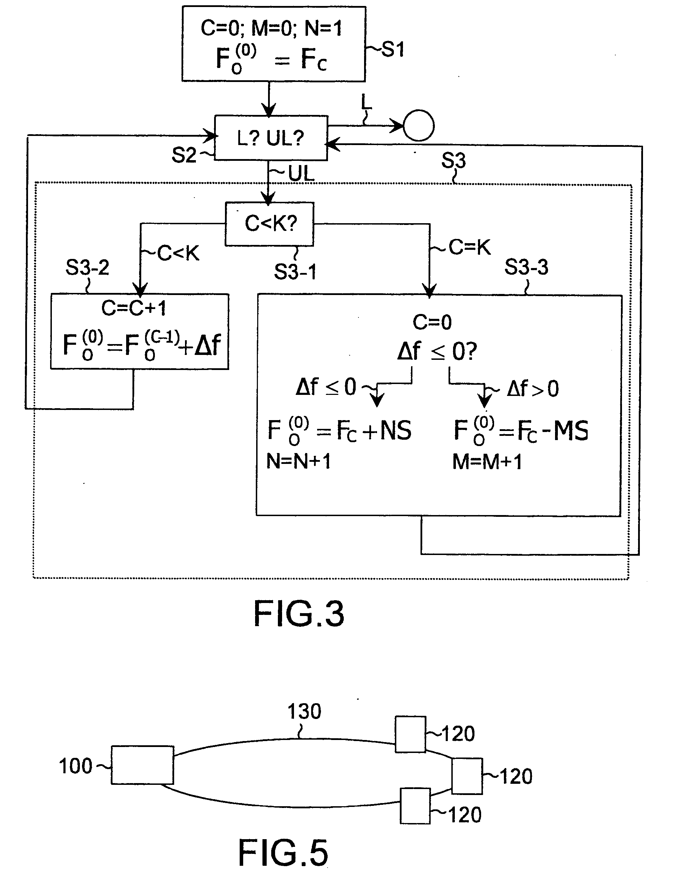

Sur la figure 5 on a représenté un exemple de système de communication selon l'invention. Ce système de communication comporte une station de tête 100 qui est un émetteur au sens de l'invention, des terminaux utilisateurs 120 qui sont des récepteurs au sens de l'invention, et un média de transmission 130. La station de tête 100 émet des signaux vers les terminaux utilisateurs par l'intermédiaire du média de transmission 130. Le média de transmission 130 est par exemple constitué d'un réseau câblé, ou d'un réseau de transmission par satellite.

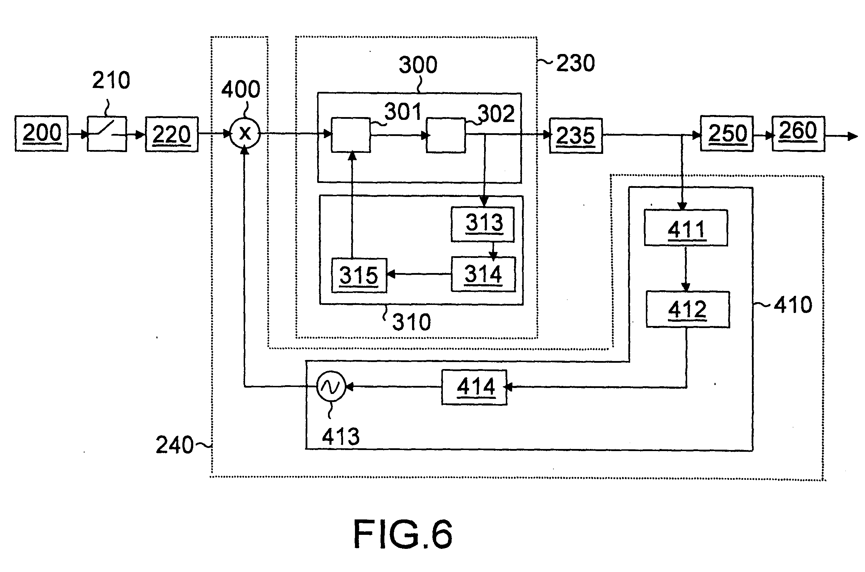

Sur la figure 6 on a représenté un exemple de récepteur selon l'invention. Un tel récepteur comporte un circuit classique de démodulation 200 qui délivre un signal transposé en bande de base. Ce signal en bande de base est échantillonné par un dispositif de sur - échantillonnage 210. Les échantillons prélevés sont fournis à un circuit de contrôle automatique de gain 220. Les échantillons obtenus à la sortie du circuit de contrôle automatique de gain sont traités par un circuit 230 de récupération d'horloge. Le circuit 230 de récupération d'horloge détermine l'instant d'échantillonnage optimal et régénère des symboles à partir des échantillons prélevés. Ces symboles sont fournis à un égaliseur 235 puis à un circuit 240 de récupération de porteuse. Les symboles délivrés en sortie du circuit 240 de récupération de porteuse sont fournis à un circuit 250 de correction de phase. Les symboles corrigés sont ensuite traités par des moyens classiques de décodage 260.

Le circuit 230 de récupération d'horloge et le circuit 240 de récupération de porteuse comportent chacun une boucle à verrouillage de phase selon l'invention.

Le circuit 230 de récupération d'horloge comporte un module de correction 300 et une boucle à verrouillage de phase 310. Le module de correction 300 est composé d'un interpolateur 301 et d'un filtre de Nyquist 302. L'interpolateur 301 reçoit une pluralité d'échantillons d'entrée et génère un échantillon de sortie qui doit coïncider avec un symbole reçu. La boucle à verrouillage de phase 310 comporte un détecteur 313, un filtre de boucle 314, et un contrôleur 315. Le détecteur 313 détecte une erreur en fréquence à partir des symboles disponibles en sortie du filtre de Nyquist. Le filtre de boucle 314 est un filtre passe-bas du second ordre qui a pour fonction d'intégrer les erreurs obtenues pour fournir une correction en fréquence au contrôleur 315. Le contrôleur 315 comporte un oscillateur contrôlé numériquement selon un procédé d'asservissement tel que décrit en référence à la figure 3. L'oscillation générée est utilisée par le contrôleur pour indiquer à l'interpolateur 301 l'échantillon qu'il doit calculer. Lorsque le verrouillage est atteint, chaque échantillon de sortie coïncide avec un symbole reçu.

Le circuit 240 de récupération de porteuse comporte un module de correction 400 et une boucle à verrouillage de phase 410. Le module de correction 400 est constitué par un multiplicateur placé à l'entrée du circuit 230 de récupération d'horloge. La boucle à verrouillage de phase 410 comporte un détecteur 411, un filtre de boucle 412, et un oscillateur 413 contrôlé numériquement par un contrôleur 414 selon un procédé d'asservissement tel que décrit sur la figure 3. Le détecteur reçoit les symboles délivrés par l'égaliseur 235. Il détermine une erreur en fréquence à partir de ces symboles. Le filtre de boucle 412 intègre les erreurs obtenues pour fournir une correction au contrôleur 414. Le contrôleur 414 commande l'oscillateur 413. L'oscillation fournie est appliquée au multiplicateur afin de corriger la fréquence de démodulation des échantillons d'entrée du circuit de récupération d'horloge 230.

## Revendications

1. Système de communication comprenant au moins un émetteur de signaux et un récepteur de signaux, ledit récepteur de signaux étant doté d'au moins une boucle à verrouillage de phase qui comporte un détecteur d'erreur et des moyens d'asservissement d'un oscillateur local susceptible de parcourir une certaine bande de fréquence, morceau par morceau, en vue de minimiser une erreur déterminée par ledit détecteur d'erreur, caractérisé en ce que lesdits moyens d'asservissement comportent :
- des moyens pour choisir un morceau de bande initial à parcourir, proche du centre de ladite bande de fréquence,
- des moyens pour choisir comme morceau de bande suivant à parcourir, le morceau non-encore parcouru le plus proche du morceau initial dans le sens des fréquences croissantes ou décroissantes, en fonction d'un critère prédéfini.

2. Système de communication selon la revendication 1, caractérisé en ce que ledit critère est constitué par le signe de l'erreur obtenue pour le morceau de bande précédent.

3. Récepteur de signaux destiné à être utilisé dans un système de communication selon la revendication 1.

4. Récepteur de signaux destiné à être utilisé dans un système de communication selon la revendication 2.

5. Circuit intégré comprenant au moins une boucle à verrouillage de phase qui comporte un détecteur d'erreur et des moyens d'asservissement d'un oscillateur local susceptible de parcourir une certaine bande de fréquence, morceau par morceau, en vue de minimiser une erreur déterminée par ledit détecteur d'erreur, caractérisé en ce que lesdits moyens d'asservissement comportent :
- des moyens pour choisir un morceau de bande initial à parcourir, proche du centre de ladite bande de fréquence,
- des moyens pour choisir comme morceau de bande suivant à parcourir, le morceau non-encore parcouru le plus proche du morceau initial dans le sens des fréquences croissantes ou décroissantes, en fonction d'un critère prédéfini.

6. Circuit intégré selon la revendication 5, caractérisé en ce que ledit critère est constitué par le signe de l'erreur obtenue pour le morceau de bande précédent.

7. Procédé d'asservissement d'un oscillateur local destiné à être utilisé dans une boucle à verrouillage de phase comportant un détecteur d'erreur, et susceptible de parcourir une certaine bande de fréquence, morceau par morceau, en vue de minimiser une erreur déterminée par ledit détecteur d'erreur,
caractérisé en ce qu'il comprend :
- une étape de sélection d'un morceau de bande initial à parcourir, ledit morceau de bande initial étant proche du centre de ladite bande de fréquence,
- une étape de sélection d'un morceau de bande suivant à parcourir, ledit morceau de bande suivant à parcourir étant constitué par le morceau de bande non-encore parcouru le plus proche du morceau initial dans le sens des fréquences croissantes ou décroissantes, en fonction d'un critère prédéfini.

8. Procédé d'asservissement selon la revendication 7, caractérisé en ce que ledit critère est constitué par le signe de l'erreur obtenue pour le morceau de bande précédent.

9. Programme d'ordinateur comportant des moyens pour l'exécution d'un procédé selon la revendication 7 pour contrôler un oscillateur local d'une boucle à verrouillage de phase.
